(19) Europäisches Patentamt
European Patent Office
Office européen des brevets

(11) **EP 3 678 287 B1**

(12) **EUROPEAN PATENT SPECIFICATION**

(45) Date of publication and mention
of the grant of the patent:
**22.11.2023 Bulletin 2023/47**

(21) Application number: **18851051.5**

(22) Date of filing: **28.08.2018**

(51) International Patent Classification (IPC):
*H02M 1/08* (2006.01)   *H03K 17/687* (2006.01)
*H03K 17/16* (2006.01)   *H02M 7/00* (2006.01)
*H03K 17/0812* (2006.01)

(52) Cooperative Patent Classification (CPC):
**H03K 17/162; H02M 7/003; H03K 17/08122;
H03K 17/08128; H03K 17/168; H03K 17/687;**
H02M 1/08

(86) International application number:
**PCT/JP2018/031769**

(87) International publication number:
**WO 2019/044832 (07.03.2019 Gazette 2019/10)**

(54) **POWER CONVERSION DEVICE AND POWER CONVERSION METHOD**

LEISTUNGSUMWANDLUNGSVORRICHTUNG UND LEISTUNGSUMWANDLUNGSVERFAHREN

DISPOSITIF ET PROCÉDÉ DE CONVERSION DE COURANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.08.2017 JP 2017165563
29.09.2017 JP 2017192238**

(43) Date of publication of application:
**08.07.2020 Bulletin 2020/28**

(73) Proprietor: **Hitachi, Ltd.
Tokyo 100-8280 (JP)**

(72) Inventors:
• **KURIHARA, Naoki**
  **Tokyo 100-8280 (JP)**
• **NAKATA, Kiyoshi**
  **Tokyo 100-8280 (JP)**
• **ISHIKAWA, Katsumi**
  **Tokyo 100-8280 (JP)**
• **KOUNO, Yasuhiko**
  **Tokyo 100-8280 (JP)**

(74) Representative: **Mewburn Ellis LLP
Aurora Building
Counterslip
Bristol BS1 6BX (GB)**

(56) References cited:
JP-A- H03 162 010     JP-A- H10 257 754
JP-A- H10 257 754     JP-A- 2003 134 836
JP-A- 2011 077 462    JP-A- 2011 244 572
US-A- 5 977 743       US-A1- 2016 308 523

## Description

Technical Field

The present invention relates to a power conversion device and a power conversion method, and is particularly suitable for being applied to a large-power power conversion device used for a railroad vehicle driven by a motor, a steel rolling mill, a wind power generator, and the like.

Background Art

A power conversion device that converts large power between DC and AC for a railroad vehicle, a steel rolling mill, a wind power generator, and the like uses, as a switching element for power conversion, a power semiconductor element that can control a large current of several hundred amperes or larger under a high voltage exceeding 1 kV. For example, a power conversion device using an IGBT (Insulated Gate Bipolar Transistor) as a switching element has been known (Patent Literature 1).
The IGBT is a composite bipolar element in which an input part has a MOSFET structure, an output part has a bipolar structure, and both of a low saturated voltage and a relatively-fast switching characteristic are realized. The IGBT includes two main terminals (a collector terminal and an emitter terminal) that energize a main power supply and a gate terminal as a control terminal that controls a current, and a gate drive circuit for controlling a gate voltage is connected to the gate terminal. When the gate drive circuit changes a gate voltage, a main current flowing between the collector terminal and the emitter terminal is controlled.
On the other hand, in order to improve the efficiency of the power conversion device and to downsize the same, an element of a wide band gap semiconductor such as SiC (silicon carbide), GaN (gallium nitride), or diamond instead of silicon has been applied to the power conversion device (Nonpatent Literature 1).
Since the dielectric breakdown field intensity of the wide band gap semiconductor is several times as large as silicon (about 10 times in the case of SiC and GaN and about 30 times in the case of diamond), the impurity concentration of a chip can be increased, and further the thickness of the chip can be configured thinner. Accordingly, conductive resistance at the time of current energization is reduced, and a conduction loss can be decreased. Thus, since the conductive resistance of a switching element is suppressed to be small, a power MOSFET having a faster switching characteristic and a unipolar structure instead of the IGBT having a bipolar structure can be used as the switching element. Further, while a silicon semiconductor can withstand up to about 200°C, the wide band gap semiconductor can withstand higher temperatures exceeding 200°C. Thus, the power converter can be downsized by simplifying a cooler of the power converter.

[Citation List]

[Patent Literature]

[Patent Literature 1] Japanese Unexamined Patent Application Publication No. 2015-198545
JP H10-257754 describes an inductance 2, a first switching element 3 and a control electrode 5 being connected in series between the control electrode and the cathode of a current controlled switching element 1, while a second switching element 4 is connected in parallel between the control electrode and the cathode of the element 1 and a diode 6 is connected in parallel between the joint of the inductance 2 and the first switching element 3 and the joint of the control electrode 5 and the diode 6. Current flowing through the inductance 2 is substantially kept constant by turning the first switching element 3 on/off while turning the second switching element 4 is turned on and it is commutated to the control electrode of the element 1 by turning the second switching element 4 off.

[Nonpatent Literature]

[Nonpatent Literature 1] "Gate-Driver with Full Protection for SiC-MOSFET Modules", VDE Conference Publication, Karsten Fink and Andreas Volke, Power Integrations GmbH, Germany, Winson Wei, Power Integrations, China, and Eugen Wiesner and Eckhard Thal, Mitsubishi Electric Europe B.V., Germany, Date of Conference: 28-30 June 2016.

Summary of Invention

Technical Problem

A gate drive circuit is connected to a switching element through a wiring (gate wiring), and the wiring length is about 50 cm to 1 m. The wiring length is made long to prevent malfunction of the gate drive circuit due to electromagnetic noise at the time of switching performed by a power semiconductor element using a high voltage and a large current. Although it has been described that the cooler of the power conversion device can be downsized by applying the wide band gap semiconductor to the switching element of the power converter, the deterioration of the gate drive circuit can be suppressed by increasing the wiring length to avoid an influence of heat generation of the switching element on the gate drive circuit.

In addition, when the switching element is turned off, or when the current of a free-wheel diode connected to the switching element in antiparallel is in an off state (hereinafter, also referred to as "reverse recovery"), a voltage between a collector and an emitter of the switching element is steeply changed, and thus a current flows to a gate from the collector through a feedback capacitance between the collector and the gate, leading to fluctuation of the gate voltage. As a result, malfunction of the switching element occurs. In order to avoid this, connection of a capacitor between gate and emitter terminals of the switching element has been also attempted.

The fluctuation of the gate voltage due to the feedback capacitance is also increased in the wide band gap semiconductor. Even if the impurity concentration of a MOSFET using the wide band gap semiconductor is increased to reduce the resistance and the thickness thereof is reduced, the feedback capacitance is reversely increased.

However, if an attempt to apply a capacitor to the switching element is made, there are problems that the capacitance of the capacitor is decreased due to heat generation at the time of switching when the capacitor is directly connected to the switching element, a connection part of the capacitor is disconnected, and the capacitor short-circuits.

Accordingly, it is conceivable to connect the capacitor to the gate drive circuit side through the already-described long gate wiring. This configuration reduces an effect of suppressing the fluctuation of the gate voltage.

In order to solve such problems, an object of the present invention is to propose a power conversion device and a power conversion method in which when a gate drive circuit is connected separately from a switching element and the temperature of the switching element becomes high due to a switching operation, malfunction of the switching element is prevented by suppressing fluctuation of a gate voltage to improve the reliability.

Solution to Problem

In order to achieve the above-described object, the present invention provides a power conversion device and a power conversion method according to the independent claims. Advantageous Effects of Invention

According to the present invention, it is possible to propose a power conversion device and a power conversion method in which when a gate drive circuit is connected separately from a switching element and the temperature of the switching element becomes high due to a switching operation, malfunction of the switching element is prevented by suppressing fluctuation of a gate voltage to improve the reliability.

Brief Description of Drawings

Fig. 1 is a block diagram of a power conversion device according to a first embodiment.
Fig. 2 is a perspective view of a gate wiring body of the power conversion device shown in Fig. 1 when obliquely viewing the entirety of the gate wiring body.
Fig. 3 is a circuit diagram for showing an electrical configuration example of the power conversion device shown in Fig. 1.
Figs. 4 show an example of operation waveforms of the power conversion device shown in Fig. 1.
Fig. 5 is a block diagram for showing a state in which a parasitic current flows.
Fig. 6 is a block diagram of a power conversion device according to a second embodiment.
Fig. 7 is a block diagram of a power conversion device according to a third embodiment not covered by the claims.
Fig. 8 is a block diagram of a power conversion device according to a fourth embodiment.
Fig. 9 is a block diagram of a power conversion device according to a fifth embodiment.
Fig. 10 is a block diagram of a power conversion device according to a sixth embodiment.
Fig. 11 is a block diagram of a power conversion device according to a seventh embodiment not covered by the claims.

Description of Embodiments

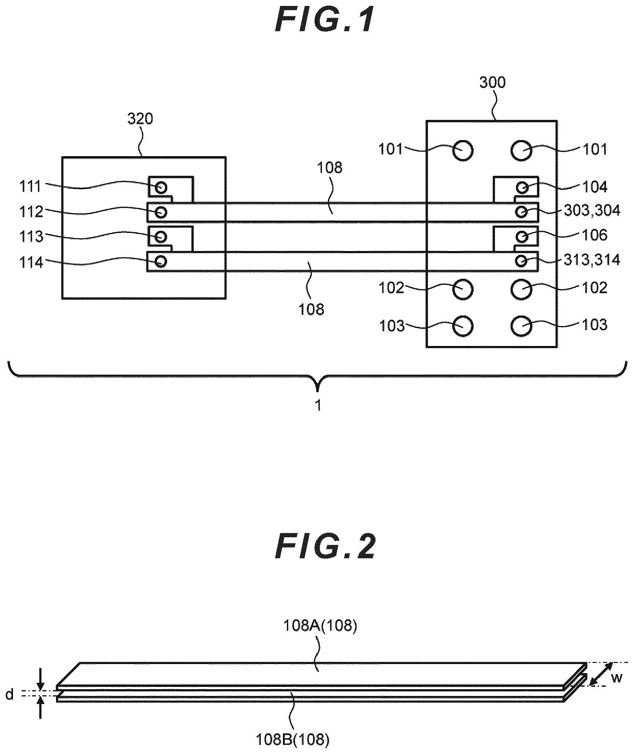

Hereinafter, embodiments of the present invention will be described on the basis of the drawings. Fig. 1 is a block diagram of a power conversion device according to a first embodiment, and is a block diagram of a switching system of a power conversion device in detail. A power conversion device 1 includes a switching module 300 having a switching element, a gate drive circuit (gate driver) 320, and gate wiring bodies 108 as wirings through which these are electrically connected to each other.

Hereinafter, the gate wiring bodies will be abbreviated as wirings or gate wirings in some cases. It should be noted that the gate wiring bodies 108 are configured using a plurality of flat plate-like conductors as preferred embodiments as will be described later (Fig. 2), and thus will be also described as gate wiring bars 108.

In addition, the switching element may be an IGBT. Hereinafter, the switching module 300 will be described as an IGBT module 300. It should be noted that the IBGT may be a silicon semiconductor or a wide band gap semiconductor. In addition, the switching element may be a power MOSFET (Metal-Oxide-Semiconductor Field-Effect Transistor) configured using a wide band gap semiconductor.

The explanation will be continued in accordance with Fig. 1. The gate driver 320 includes an upper arm source auxiliary terminal 111, an upper arm gate terminal 112, a lower arm source auxiliary terminal 113, and a lower arm gate terminal 114.

The IGBT module 300 includes AC main terminals 101, DC P-terminals 102, DC N-terminals 103, an upper arm source auxiliary terminal 104, an upper arm gate terminal 303 (corresponding to an upper arm gate terminal 105 to be described later), a lower arm source auxiliary terminal 106, and a lower arm gate terminal 313 (corresponding to a lower arm gate terminal 107 to be described later).

The upper arm gate terminal 112 is connected to the upper arm gate terminal 303 through the gate wiring bar 108, and the upper arm source auxiliary terminal 111 is provided near the upper arm gate terminal 112. The upper arm source auxiliary terminal 104 is provided near the upper arm gate terminal 303.

The lower arm gate terminal 114 is connected to the lower arm gate terminal 313 through the gate wiring bar 108, and the lower arm source auxiliary terminal 113 is provided near the lower arm gate terminal 114. The lower arm source auxiliary terminal 106 is provided near the lower arm gate terminal 313.

In the IGBT module 300, two upper arm and lower arm DC P-terminals 102 and two upper arm and lower arm DC N-terminals 103 are provided, and two upper arm and lower arm AC main terminals 101 are provided.

Next, the gate wiring body 108 will be described in detail. The gate wiring body 108 may be configured in such a mode that inductance between the IGBT module 300 and the gate driver 320 can be reduced in a range of one severalth to one several tenth as compared to wirings configured using conventional electric wires, and a plurality of conductors may oppose each other in a planar manner with a minute interval therebetween as a main mode. At least, a pair of flat plate-like conductors that are parallel to each other oppose each other. In other words, the "flat plate-like" may be changed to "rectangular", "planar", or "layered".

The gate wiring body 108 can be manufactured in such a manner that a plurality of conductors is laminated so as to sandwich a thin film-like insulator therebetween to join the insulator and the conductors together in a laminated manner. As the gate wiring bodies 108, a plurality of conductors oppose each other in a planar manner, and in an embodiment not covered by the claims, may be coaxially or concentrically combined with each other in addition to the flat plate-like conductors. Namely, an area where a conductor 108A opposes a conductor 108B is large, and an interval between the conductor 108A and the conductor 108B is set as small as possible to reduce inductance. The conductor may be made of material having conductivity such as copper or aluminum, or material such as iron or stainless material. The plane may be a flat plane or a curved plane.

Fig. 2 is a perspective view of the gate wiring bar 108 shown in Fig. 1. The gate wiring bar 108 is configured in such a manner that two flat plates 108A and 108B each having a width W oppose each other with an interval d therebetween. The inductance of the gate wiring bar 108 is set in accordance with configurations or arrangement of the two flat plates 108A and 108B opposing each other. As the flat plates 108A and 108B each having a wider area are arranged nearer each other, the inductance of the gate wiring bar 108 is reduced. For the width W and the interval d of the two flat plates 108A and 108B, a relation shown in the following Equation (1) is established.
[Equation 1]

$$W/d \geq 5 \qquad\qquad\qquad (1)$$

In order to arrange the flat plates 108A and 108B nearer each other under the conditions where the width (W) of the gate wiring bar 108 is 5 mm and the interval between the flat plates 108A and 108B is 1 mm or smaller, it is preferable to closely attach the two flat plates 108A and 108B while sandwiching a sheet-like insulating material therebetween. For example, the present invention may employ an integrally-molded laminate bus bar structure in which the two flat plates 108A and 108B are laminated while sandwiching a sheet-like insulating material therebetween and the entirety is laminated after being coated with an insulating material.

In the case where a power converter is an inverter applied to a train for a regular railroad line, the wiring length of the gate wiring bar 108 is about 50 cm to 1 m. While the maximum inductance of wirings configured using a pair of electric wires is 1 μH, the inductance of the gate wiring bar 108 is reduced to 200 nH or smaller.

When the inductance in the case where the gate driver 320 and the IGBT module 300 are connected to each other through an electric wire under the conditions where the interval between the gate driver 320 and the IGBT module 300 is 50 cm and the size of the gate wiring bar 108 is set as described above is compared to the inductance in the case where the gate driver 320 and the IGBT module 300 are connected to each other through the gate wiring bar 108, the former is about 350 nH whereas the latter is reduced to about 30 nH.

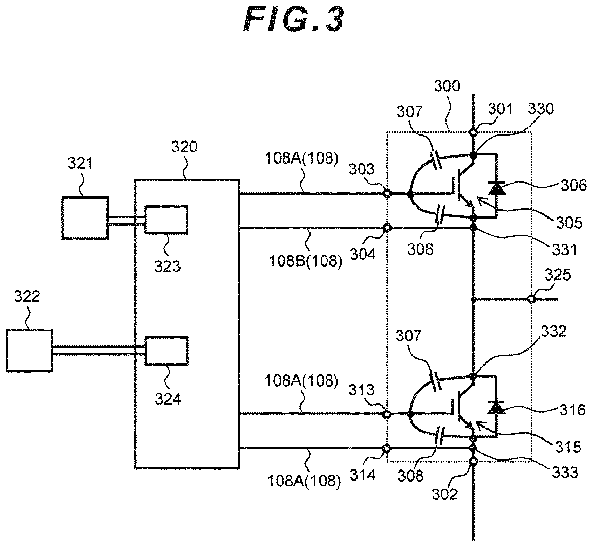

Fig. 3 is a circuit diagram of the IGBT module 300 and the gate driver 320 as an electrical configuration example. The IGBT module 300 is a so-called 2in1-type IGBT module. Two IGBTs 305 and 315 as switching elements are included in one package, and are connected in series at a connection point with an AC input/output terminal 325 connected to the above-described AC main terminal 101. In the IGBT module 300, the lower arm has the same configuration as the upper arm, and thus the description of the upper arm is mainly substituted for that of the lower arm except for a case in which the lower arm needs to be particularly referred to.

In the gate driver 320, the upper arm source auxiliary terminal 111, the upper arm gate terminal 112, the lower arm source auxiliary terminal 113, and the lower arm gate terminal 114 described in Fig. 1 are omitted.

An upper arm free-wheel diode 306 is connected to the IGBT 305 in antiparallel. In the case where a current flows in the upper arm free-wheel diode 306 in the direction opposite to the IGBT 305, the current is recirculated. In the case where the power semiconductor element 305 is a power MOSFET, a free-wheel diode 109 can be configured using, for example, a MOSFET-incorporated body diode.

On/off of the IGBT 305 is controlled in accordance with a voltage applied to a gate terminal 303 (corresponding to an upper arm gate main terminal to be described later) and an emitter auxiliary terminal 304. When a positive voltage is applied to the gate terminal 303 in the IGBT 305, a current flows from an upper arm collector 330 towards an upper arm emitter 331.

The gate driver 320 generates a voltage applied to the gate terminal 303 of the IGBT 305. The gate driver 320 generates a gate voltage on the basis of a driving command from a gate command unit (gate command module) 322 that entirely controls the inverter system, and outputs the same to the gate terminal 303 of the IGBT 305. The gate command unit 322 may be configured using software and/or hardware.

The gate driver 320 and the gate command unit 322 are coupled to each other through a photo coupler 324, and the IGBT 305 and the like to which a high voltage is applied are insulated from the gate command unit 322. A power supply for driving the gate driver 320 is supplied from a gate power supply 321 through a gate power supply transformer 323 that is an insulating transformer.

The gate driver 320 and the IGBT module 300 are connected to each other through the two flat plates 108A and 108B configuring the above-described gate wiring bar 108 in each case of the upper arm and the lower arm. While a parasitic capacitance 307 referred to as "feedback capacitance" is present between the upper arm collector main terminal 301 connected to the DC P-terminal 102 and the upper arm gate main terminal 303 (corresponding to the gate terminal), and a parasitic capacitance 308 referred to as "input capacitance" is present between the upper arm gate main terminal 303 and the upper arm emitter 331.

When the IGBT 305 is switched, a parasitic current flows from the upper arm collector main terminal 301 to the upper arm gate main terminal 303 through the parasitic capacitance 307 referred to as "feedback capacitance" due to a steep change of a voltage applied between the upper arm collector main terminal 301 and the upper arm emitter 331. Thus, there is a risk that the gate voltage of the upper arm gate main terminal 303 fluctuates to cause malfunction. However, in the power conversion device according to the present invention, at least a part of wirings between the gate driver 320 and the module 300 is changed to the gate wiring bar 108 so as not to cause such a phenomenon.

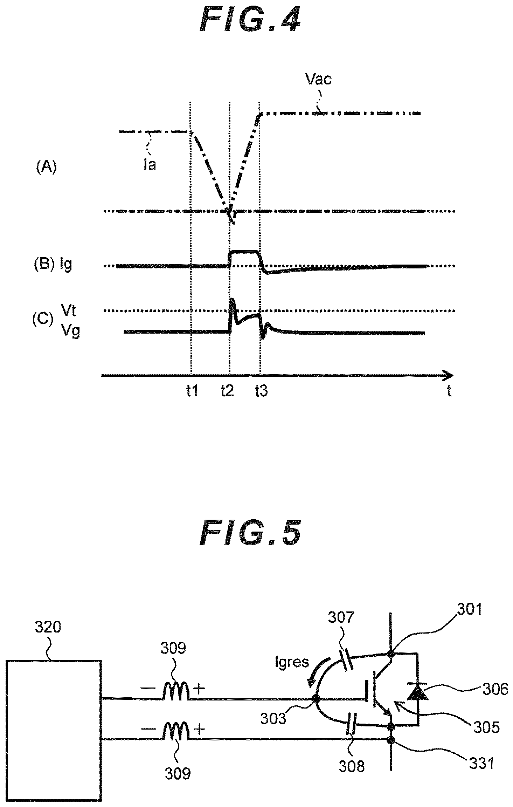

Each of Fig. 4(A) to Fig. 4(C) shows an example of each waveform at the time of reverse recovery of the upper arm free-wheel diode 306 connected to the IGBT 305 in antiparallel.

In Fig. 4(A), the one-dot chain line shows an example of an anode current Ia of the upper arm free-wheel diode 306, and the two-dot chain line shows an example of a voltage Vac between the anode and the cathode of the upper arm free-wheel diode 306. Fig. 4(B) shows an example of a gate current Ig flowing in the upper arm gate main terminal 303 of the IGBT 305, and Fig. 4(C) shows an example of a gate voltage Vg in the upper arm gate main terminal 303 of the IGBT 305.

As shown by the one-dot chain line in Fig. 4(A), the anode current Ia of the upper arm free-wheel diode 306 flowed in the forward direction until Time t1. However, a voltage Vac between the anode and the cathode fluctuates in the course of a turn of the flow thereafter as shown by the two-dot chain line in Fig. 4(A). As shown by the one-dot chain line in Fig. 4(A), a turn of the flow of the anode current Ia of the upper arm free-wheel diode 306 starts at Time t1.

As shown by the one-dot chain line in Fig. 4(A), when the anode current Ia becomes 0 at Time t2, a voltage is sharply applied to both ends (the upper arm collector main terminal 301 and the upper arm emitter 331) of the upper arm free-wheel diode 306 as shown by the two-dot chain line in Fig. 4(A). Such a sharply-changed voltage is also applied to the IGBT 305 connected in antiparallel, and thus a voltage Vce between the upper arm collector main terminal 301 and the upper arm emitter 331 in the IGBT 305 is changed in accordance with the voltage change rate dVce/dt.

Fig. 5 shows an example of a state in which a parasitic current Igres flows between the upper arm collector main terminal 301 and the upper arm gate main terminal 303 in the IGBT 305. In general, the parasitic capacitance 307 referred to as "feedback capacitance" (the value of which is described as Cres) is present between the upper arm collector main terminal 301 and the upper arm gate main terminal 303 in the IGBT 305 as described above, and thus the parasitic current Igres shown in the following Equation (2) flows from the upper arm collector main terminal 301 to the upper arm gate main terminal 303 in accordance with the change of the voltage.

[Equation 2]

$$Igres = Cres \times dVce/dt \qquad (2)$$

The parasitic current Igres separately flows to the above-described input capacitance (the value of which is described as Cies) of the IGBT 305 and the gate driver 320. If the impedance of the output circuit and the gate wiring of the gate driver 320 is small, the parasitic current Igres fully flows to the gate driver 320 and does not charge the parasitic capacitance 308 referred to as "input capacitance". Thus, the gate voltage of the gate wiring does not fluctuate. It should be noted that the gate wiring described herein corresponds to the gate wiring bar 108 in the case of the embodiment.

On the other hand, in the case where the impedance of the output circuit of the gate driver 320 and the inductance 309 of the gate wiring (corresponding to the gate wiring bar 108 in the case of the embodiment) are large as described above, the parasitic current Igres flows to and charges the parasitic capacitance 308 referred to as "input capacitance". Thus, there is a risk that the gate voltage of the upper arm gate main terminal 303 of the IGBT 305 is increased as shown in Fig. 4(C).

In the case where the parasitic current Igres is large, the IGBT 305 is erroneously turned on if the gate voltage Vg of the upper arm gate main terminal 303 exceeds a threshold value voltage Vt of the IGBT 305. The inductance 309 of the gate wiring is dependent on the length of the gate wiring. As the length of the gate wiring becomes long, the inductance 309 is increased, and the possibility of erroneously turning on the IGBT 305 is enhanced.

As a countermeasure against such a phenomenon, at least a part of the gate wirings of the IGBT 305 is configured using the gate wiring bar 108 including the pair of flat plates 108A and 108B that oppose and are adjacent to each other in the embodiment as described above.

In the power conversion device 1 including the gate wiring bar 108 configured as described above, since the inductance of the gate wiring bar 108 is suppressed to be small by these flat plates 108A and 108B, the parasitic current Igres flows to the gate driver 320, and does not charge the parasitic capacitance 308 referred to as "input capacitance". In addition, the gate voltage of the gate wiring does not fluctuate. Thus, the IGBT 305 is prevented from being erroneously turned on.

If the gate driver 320 is arranged apart from a position that is not affected by rise in temperature, the gate voltage of the IGBT 305 can be prevented from fluctuating by employing the gate wiring bar 108 having such a configuration to perform power conversion in the embodiment. Thus, even when the gate driver 320 is used at high temperatures where the performance of the wide band gap semiconductor is utilized, the reliability of the gate driver 320 is not deteriorated, and both of downsizing of the system and improvement in reliability can be realized along with high flexibility of arrangement. Moreover, since it is not necessary to arrange the gate driver 320 near a semiconductor element, the flexibility of arrangement can be enhanced, and the usability of the gate driver 320 can be improved by enhancing accessibility to the gate driver 320 at the time of maintenance.

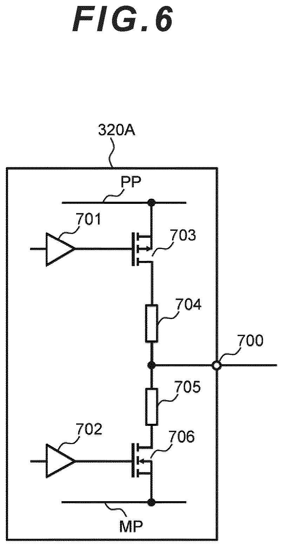

Fig. 6 is a diagram for describing a second embodiment, and is a circuit diagram for showing a configuration example of an output circuit 320A configuring a part of the gate driver 320 of the power conversion device. It should be noted that circuit elements other than the output circuit 320A are not illustrated.

The configurations and operations of the output circuit 320A almost the same as those in the first embodiment will not be described, and different points between the both will be mainly described below.

In the second embodiment, as an example, complementary MOSFETs are employed for a P-MOSFET 703 and an N-MOSFET 706 as switching elements of the output circuit 320A.

In the case where a predetermined driving command is input to each of a positive-side pre-buffer 701 and a negative-side pre-buffer 702 when the IGBT and SiC element are turned on in the output circuit 320A, an output of the positive-side pre-buffer 701 becomes a low level, and the P-MOSFET 703 is turned on. On the other hand, the N-MOSFET 706 is turned off. Accordingly, a positive voltage is output from a positive power supply line PP to a gate terminal 700 connected to the above-described gate wiring bar 108, and thus the output circuit 320A turns on the IGBT and SiC element.

On the other hand, in the case where a predetermined driving command is input to each of the positive-side pre-buffer 701 and the negative-side pre-buffer 702 when the IGBT and SiC element are turned off in the output circuit 320A, an output of the positive-side pre-buffer 701 is inverted to become a high level, and the P-MOSFET 703 is turned off. On the other hand, the N-MOSFET 706 is turned on. Accordingly, a negative voltage is output from a negative power supply line MP to the gate terminal 700 connected to the above-described gate wiring bar 108, and thus the output circuit 320A turns off the IGBT and SiC element.

Even in the case where a current is about to flow due to the feedback capacitance of the SiC-MOSFET when the SiC-MOSFET is in an OFF state, an operation delay can be suppressed as compared to a bipolar transistor because instead of a bipolar transistor, a MOSFET that is a unipolar device is employed as a switching element of the output circuit 320A in the embodiment. Therefore, according to the embodiment, the gate voltage of the SiC-MOSFET can be prevented from fluctuating as similar to the above-described first embodiment.

It should be noted that electric charges are discharged from a capacitor 1020 by turning on the N-MOSFET 706 and turning off the P-MOSFET 703 using an OFF command for setting the positive-side pre-buffer 701 high and the negative-side pre-buffer 702 high in the output circuit 320A in Fig. 6.

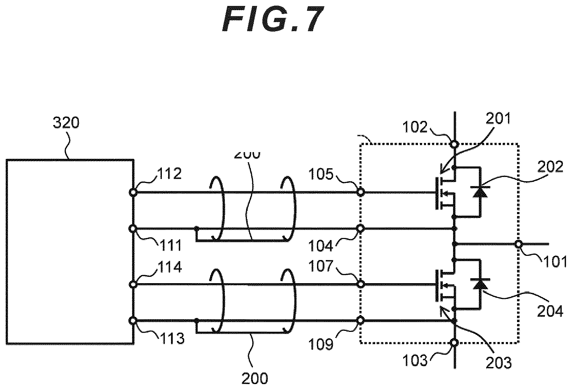

Fig. 7 is a block diagram of a power conversion device according to a third not covered by the claims. The third embodiment clarifies that the gate wiring body 108 is a coaxial cable 200 of at least a part of gate wirings. As similar to the already-described gate wiring bar 108, the coaxial cable 200 is configured in such a manner that a plurality of conductors opposes each other in a planar manner with a minute interval therebetween. More specifically, two conductors are concentrically present, and can reduce the inductance. In general, since both ends of the coaxial cable 200 are of a so-called BNC type, the inductance at a connection part can be reduced by using a BCN-type connector of the gate driver 320.

The coaxial cable 200 suppresses the inductance of the gate wiring by connecting an upper arm gate terminal 105 on the SiC module 300 side including an upper arm SiC 201 and a lower arm SiC 203 to an upper arm gate terminal 112 on the gate driver 320 side.

It should be noted that as similar to the already-described embodiments, an upper arm free-wheel diode 202 is connected to the upper arm SiC 201 in antiparallel and a lower arm free-wheel diode 204 is connected to the lower arm SiC 203 in antiparallel in the third embodiment.

The above-described coaxial cable 200 may be provided at, at least a part of the gate wiring connecting the upper arm source auxiliary terminal 104 on the SiC module 300 side to the upper arm source auxiliary terminal 111 on the gate driver 320 side.

On the other hand, also on the lower arm side as similar to the upper arm, the coaxial cable 200 may be provided at, at least, a part of the gate wiring connecting the lower arm gate terminal 107 on the SiC module 300 side to the lower arm gate terminal 114 on the gate driver 320 side, or may be provided at, at least, a part of the gate wiring connecting the lower arm source auxiliary terminal 109 on the SiC module 300 side to the lower arm source auxiliary terminal 113 on the gate driver 320 side.

According to the third embodiment, as similar to the first and second embodiments, the inductance can be reduced, and thus the gate voltage can be prevented from fluctuating by the presence of such a coaxial cable 200 as compared to the linear gate wiring.

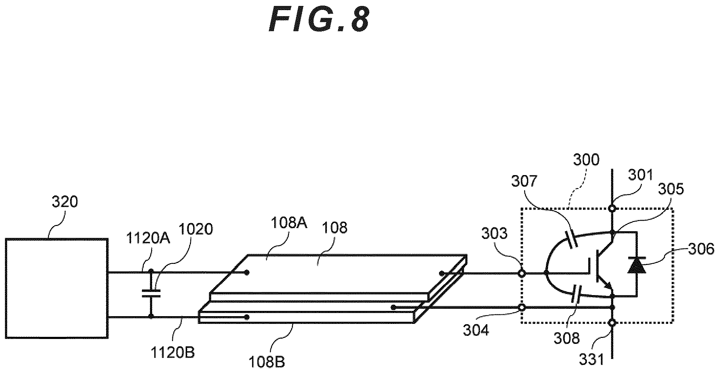

Next, a power conversion device according to a fourth embodiment will be described. Fig. 8 is a block diagram thereof. In Fig. 8, the IGBT module 300 is illustrated as a 1in1 type in which one element is accommodated in one package. The embodiment is different from the already-described embodiments in that the gate voltage can be more effectively prevented from fluctuating by the feedback capacitance 307 by providing the capacitor 1020 in addition to the gate wiring body bar 108. It should be noted that the signs in the IGBT module 300 in Fig. 8 are the same as those of the IGBT of the upper arm of Fig. 1.

The capacitor 1020 to suppress the fluctuation of the gate voltage is arranged between the gate driver 320 and the gate wiring bar 108, namely, on the gate driver 320 side relative to the switching module 300 or near the gate driver 320. One end of the capacitor 1020 is connected to a wiring 1120A connecting one of a pair of output terminals of the gate driver 320 to the conductor 108A, and the other end of the capacitor 1020 is connected to a wiring 1120B connecting the other output terminal of the gate driver 320 to the conductor 108B.

When the current of the free-wheel diode 306 is off, namely, at the time of reverse recovery, a voltage between the collector terminal 301 and the emitter terminal 331 is sharply increased, and a current flows from the collector terminal 301 to the gate terminal 303 through the feedback capacitance 307 along with a sharp increase in voltage. The current flows to the gate driver 320, and the potential rise of the gate terminal 303 can be suppressed.

When the inductance of the gate wiring is high, a current flows from the feedback capacitance 307 to the input capacitance 308, and thus the voltage of the gate terminal 303 is increased. When the voltage exceeds the threshold value voltage of the IGBT 305, the IGBT 305 is mistakenly turned on.

On the contrary, the inductance of the gate wiring body 108 itself can be sufficiently reduced. In addition, the capacitor 1020 sufficiently absorbs a current flowing in from the feedback capacitance 307 by combining the capacitor 1020 for suppressing the fluctuation of the gate voltage to eliminate or remarkably reduce the current flowing into the input capacitance 308, so that the voltage of the gate terminal 303 is prevented from fluctuating.

Even if the capacitor 1020 for suppressing the fluctuation of the gate voltage is not directly connected to the switching module 300 but is connected between the gate wiring body 108 and the gate driver 320, a current flowing in from the feedback capacitance 105 can be sufficiently induced by the capacitor 1020 because the inductance of the gate wiring body 108 itself is sufficiently low.

The optimum value of the capacitance of the capacitor 1020 may be selected in a range of half to twice the input capacitance of the IGBT 305. For example, in the case of an IGBT having a rated voltage of 3.3kV and a rated current of 1200 A, the input capacitance is about 100 nF, and the capacitance of the capacitor 1020 may be selected in a range of 50 nF to 200 nF.

Since the capacitor 1020 is positioned on the gate driver 320 side apart from the switching module 300 through the gate wiring body 108, the capacitor 1020 is less affected by heat generation of the switching module 300, and the lifetime of the capacitor 1020 can be prevented from shortening.

For example, even in the case where the gate driver 320 has been used over a long period of about twenty years, the function of the capacitor 1020 is not deteriorated. Thus, the fluctuation of the voltage of the gate terminal 303 of the IGBT 305 can be certainly suppressed over a long period, and the malfunction of the IGBT 305 can be prevented. As a result, even if the power conversion device performs power conversion by inputting a control signal from a pair of output terminals of the gate driver 320 to the switching module 300, the reliability of power conversion can be improved.

Further, since the capacitor 1020 for suppressing the fluctuation of the gate voltage can be arranged apart from the switching module 300, it is not necessary to secure withstand voltage for the capacitor 1020. In addition, the cost of the capacitor 1020 can be suppressed, and the size thereof can be reduced.

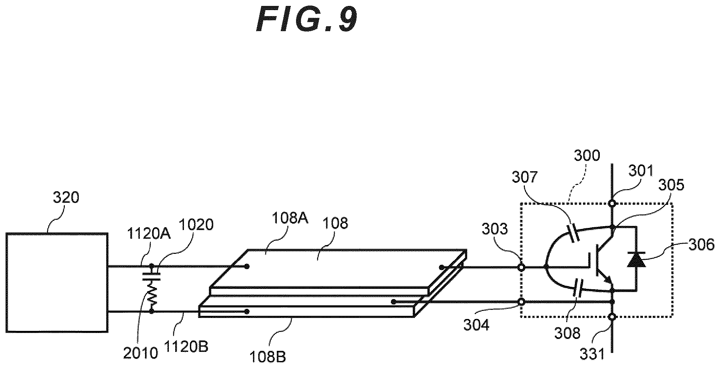

Next, Fig. 9 is a block diagram of a power conversion device according to a fifth embodiment. The fifth embodiment is different from the fourth embodiment in that a damping resistor 2010 connected in series to the capacitor 1020 between one wiring and the other wiring connecting the gate driver 320 to the gate wiring body 108 is provided.

When a frequency component of a current flowing into the gate through the feedback capacitance 307 becomes the same as or near the resonance frequency of a closed circuit configured of the gate wiring body 108, the capacitor 1020, and the input capacitance 308, there is a possibility that resonance occurs in the closed circuit. The resonance condition is shown in Equation (3).

[Equation 3]

$$fc = \frac{1}{\sqrt{Lg \times Cg \times Cies/(Cg+Cies)}}$$

$$(3)$$

In Equation (3), fc represents a resonance frequency, Lg represents the inductance of a gate wiring unit 100, Cg represents the capacitance of the capacitor 1020 for suppressing the fluctuation of the gate voltage, and Cies represents an input capacitance.

In the case where many components of the resonance frequency of Equation (3) are contained in a parasitic current flowing in from the collector terminal 303 through the feedback capacitance 307 at the time of reverse recovery of the free-wheel diode 306, there is a risk that resonance occurs and the gate voltage oscillates, resulting in malfunction of the IGBT 305, or an overvoltage occurs in the gate terminal 303 to destroy the IGBT 305.

The resonance can be suppressed by adding the damping resistor 2010 to the closed circuit, and the malfunction of the IGBT 305 caused by the resonance and the destruction of the IGBT 305 due to the overvoltage of the gate terminal 303 can be prevented.

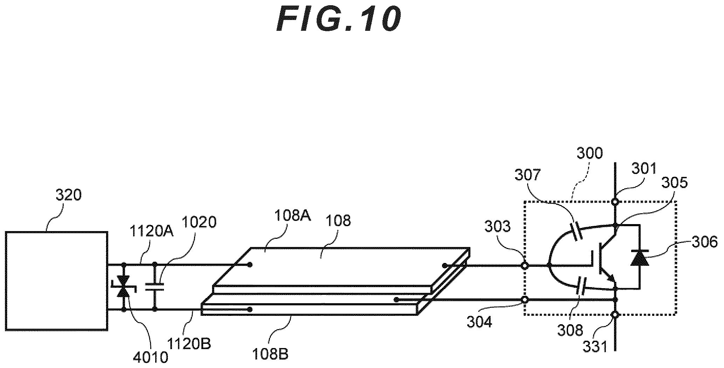

Next, Fig. 10 is a block diagram of a power conversion device according to a sixth embodiment. The power conversion device according to the sixth embodiment includes a surge absorber 4010 that is arranged between one wiring and the other wiring connecting the gate driver 320 to the gate wiring body 108, and is connected in parallel with the capacitor 1020 for suppressing the fluctuation of the voltage of the gate terminal 303, so as to remove noise on the one wiring and the other wiring.

If a part of gate wirings is replaced by the gate wiring body 108, the inductance of the wirings becomes small, and thus a surge voltage can be easily applied to the gate driver 320. Since a semiconductor element such as a comparator or an operational amplifier is present in the gate driver 320, the semiconductor element is destroyed by applying the surge voltage.

Accordingly, if the surge absorber 4010 is added near a pair of output terminals of the gate driver 320, the surge voltage is absorbed by the surge absorber 4010, and the gate driver 320 is protected from the surge voltage.

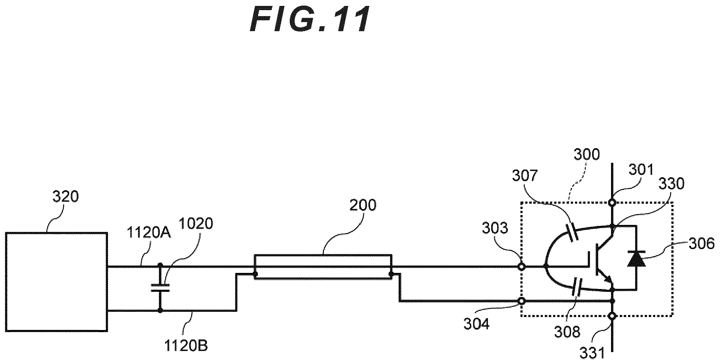

Next, Fig. 11 is a block diagram of a power conversion device according to a seventh embodiment not covered by the claims. In the seventh embodiment, the gate wiring body bar 108 of Fig. 8 is changed to the coaxial cable 200, and the capacitor 1020 for suppressing the fluctuation of the gate voltage is added to the gate driver 320 side to suppress the fluctuation of the gate voltage.

The already-described embodiments are exemplifications for describing the present invention, and the present invention is not limited to these embodiments. For example, the switching element may be not only a wide band gap semiconductor using SiC, but also another wide band gap semiconductor using GaN or diamond.

The switching element may be not only an IGBT or a power MOSFET, but also a J-FET or an SIT (Static Induction Transistor). Further, a so-called 2in1-type semiconductor obtained by accommodating two switching elements in one package and a 1in1-type semiconductor in which one switching element is mounted have been described in the above-described embodiments. However, a 6in1-type wide semiconductor in which six switching elements are mounted may be used.

Even if all the gate wirings are not replaced by the gate wiring bodies 108, a part of the gate wirings may be replaced by the gate wiring body 108 as long as the inductance can be reduced by a target amount.

Industrial Applicability

The present invention can be widely applied to a large-power power conversion device such as an inverter or converter used for a railroad vehicle driven by a motor, a steel rolling mill, a wind power generator, and the like.

List of Reference Signs

| | |
|---|---|
| 1 | power conversion device |
| 108 | gate wiring bar |
| 108A, 108B | a pair of flat plates (conductors) |
| 200 | coaxial cable |
| 300 | IGBT module |
| 320 | gate driver (gate driving device) |
| 320A | output circuit |
| 1020 | capacitor (capacitor for suppressing fluctuation of gate voltage) |
| 2010 | damping resistor |
| 4010 | surge absorber |

**Claims**

1. A power conversion device (1) that converts power between DC and AC, the device comprising:

a switching module (300) that includes a power semiconductor element (305) as a switching element;
a gate driver (320) that outputs a drive signal for driving the switching element to a control terminal of the switching module; and
a wiring body (108) that connects the control terminals of the switching module and output terminals of the gate driver using a plurality of conductors (108A, 108B) opposing each other in a planar manner with an interval therebetween,
wherein the wiring body includes a first conductor (108A) and a second conductor (108B) as the plurality of conductors,
wherein the first conductor and the second conductor are configured using flat plates that are arranged in parallel with each other,
wherein the first conductor connects one terminal of the control terminals of the switching module to one terminal of the output terminals of the gate driver,
wherein the second conductor connects the other terminal of the control terminals of the switching module to the other terminal of the output terminals of the gate driver,
wherein when each width of the first conductor and the second conductor is W and an interval between the first conductor and the second conductor is d, $W/d \geq 5$ is satisfied, and
wherein a capacitor (1020) is connected between a first wiring connecting the gate driver to the first conductor and a second wiring connecting the gate driver to the second conductor,
wherein the capacitor (1020) is positioned on the gate driver (320) side apart from the switching module (300) through the wiring body (108),
wherein the switching module accumulates a current based on a feedback capacitance (307) between a main terminal of the switching module and the control terminal into the capacitor (1020) through the wiring body, so that fluctuation of a voltage of the control terminal is suppressed by reducing the inductance between the switching module (300) and the gate driver (320) with the wiring body (108).

**2.** The power conversion device according to claim 1,
wherein an output circuit of the gate driver includes a MOSFET.

**3.** The power conversion device according to claim 1,
wherein a resistor (2010) is connected in series to the capacitor connected to the first wiring and the second wiring.

**4.** The power conversion device according to claim 1,
wherein a surge absorber (4010) is connected in parallel with the capacitor connected to the first wiring and the second wiring.

**5.** The power conversion device according to claim 1,
wherein the switching element is an insulated gate bipolar transistor or a metal-oxide-semiconductor field-effect transistor.

**6.** The power conversion device according to claim 1,
wherein the gate driver is arranged apart from the switching module in a range of 50 cm to 1 m.

**7.** A power conversion method using a power conversion device (1) that converts power between DC and AC and comprises a switching module (300) that includes a power semiconductor element (305) as a switching element, a gate driver (320) that outputs a drive signal for driving the switching element to a control terminal of the switching module, and a wiring body (108) that connects the control terminals of the switching module and output terminals of the gate driver,

wherein the wiring body connects the control terminal and an output terminal of the gate driver using a plurality of conductors opposing each other in a planar manner with an interval therebetween,
wherein a capacitor (1020) is connected between a first wiring connecting the gate driver to the first conductor and a second wiring connecting the gate driver to the second conductor,
wherein the capacitor (1020) is positioned on the gate driver (320) side apart from the switching module (300) through the wiring body (108), wherein the switching module accumulates a current based on a feedback capacitance between a main terminal of the switching module and the control terminal into the capacitor (1080) through the wiring body, so that fluctuation of a voltage of the control terminal is suppressed by reducing the inductance between the switching module (300) and the gate driver (320) with the wiring body (108),
wherein the wiring body includes a first conductor (108A) and a second conductor (108B),
wherein the first conductor and the second conductor are configured using flat plates that are arranged in parallel with each other,
wherein the first conductor connects one terminal of the control terminals of the switching module to one terminal of the output terminals of the gate driver,
wherein the second conductor connects the other terminal of the control terminals of the switching module to the other terminal of the output terminals of the gate driver,
wherein when each width of the first conductor and the second conductor is W and an interval between the first conductor and the second conductor is d, $W/d \geq 5$ is satisfied.

**Patentansprüche**

**1.** Leistungswandlervorrichtung (1), die Leistung zwischen Gleichstrom und Wechselstrom umwandelt, wobei die Vorrichtung Folgendes umfasst:

ein Schaltmodul (300), das ein Leistungshalbleiterelement (305) als Schaltelement umfasst;
einen Gate-Treiber (320), der ein Ansteuersignal zum Ansteuern des Schaltelements an einen Steueranschluss des Schaltmoduls ausgibt; und
einen Verdrahtungskörper (108), der die Steueranschlüsse des Schaltmoduls und Ausgangsanschlüsse des Gate-Treibers unter Verwendung einer Vielzahl von Leitern (108A, 108B) miteinander verbindet, die ebenenweise mit einem Abstand dazwischen einander gegenüberliegend angeordnet sind,
wobei der Verdrahtungskörper einen ersten Leiter (108A) und einen zweiten Leiter (108B) als die Vielzahl von Leitern umfasst,
wobei der erste Leiter und der zweite Leiter unter Verwendung von flachen Platten ausgelegt sind, die parallel zueinander angeordnet sind,

wobei der erste Leiter einen Anschluss der Steueranschlüsse des Schaltmoduls mit einem Anschluss der Ausgangsanschlüsse des Gate-Treibers verbindet,

wobei der zweite Leiter den anderen Anschluss der Steueranschlüsse des Schaltmoduls mit dem anderen Anschluss der Ausgangsanschlüsse des Gate-Treibers verbindet,

wobei, wenn die jeweilige Breite des ersten Leiters und des zweiten Leiters W ist und ein Abstand zwischen dem ersten Leiter und dem zweiten Leiter d ist, W/d≥5 erfüllt ist, und

wobei ein Kondensator (1020) zwischen einer ersten Verdrahtung, die den Gate-Treiber mit dem ersten Leiter verbindet, und einer zweiten Verdrahtung, die den Gate-Treiber mit dem zweiten Leiter verbindet, verbunden ist, wobei der Kondensator (1020) auf der Seite des Gate-Treibers (320) durch den Verdrahtungskörper (108) von dem Schaltmodul (300) beabstandet angeordnet ist,

wobei das Schaltmodul einen Strom basierend auf einer Rückkopplungskapazität (307) zwischen einem Hauptanschluss des Schaltmoduls und dem Steueranschluss in den Kondensator (1020) durch den Verdrahtungskörper akkumuliert, sodass Schwankungen einer Spannung des Steueranschlusses unterdrückt werden, indem die Induktivität zwischen dem Schaltmodul (300) und dem Gate-Treiber (320) mit dem Verdrahtungskörper (180) verringert wird.

2. Leistungswandlervorrichtung nach Anspruch 1, wobei eine Ausgangsschaltung des Gate-Treibers einen MOSFET umfasst.

3. Leistungswandlervorrichtung nach Anspruch 1, wobei ein Widerstand (2010) in Serie mit dem Kondensator verbunden ist, der mit der ersten Verdrahtung und der zweiten Verdrahtung verbunden ist.

4. Leistungswandlervorrichtung nach Anspruch 1, wobei ein Überspannungsschutz (4010) parallel mit dem Kondensator verbunden ist, der mit der ersten Verdrahtung und der zweiten Verdrahtung verbunden ist.

5. Leistungswandlervorrichtung nach Anspruch 1, wobei das Schaltelement ein Bipolartransistor mit isoliertem Gate oder ein Metalloxid-Halbleiter-Feldeffekttransistor ist.

6. Leistungswandlervorrichtung nach Anspruch 1, wobei der Gate-Treiber in einem Bereich von 50 cm bis 1 m vom Schaltmodul beabstandet angeordnet ist.

7. Leistungswandlungsverfahren unter Verwendung einer Leistungswandlervorrichtung (1), die Leistung zwischen Gleichstrom und Wechselstrom umwandelt und Folgendes umfasst: ein Schaltmodul (300), das ein Leistungshalbleiterelement (305) als Schaltelement umfasst; einen Gate-Treiber (320), der ein Ansteuersignal zum Ansteuern des Schaltelements an einen Steueranschluss des Schaltmoduls ausgibt; und einen Verdrahtungskörper (108), der die Steueranschlüsse des Schaltmoduls und die Ausgangsanschlüsse des Gate-Treibers miteinander verbindet,

wobei der Verdrahtungskörper den Steueranschluss und einen Ausgangsanschluss des Gate-Treibers unter Verwendung einer Vielzahl von Leitern miteinander verbindet, die ebenenweise mit einem Abstand dazwischen einander gegenüberliegend angeordnet sind,

wobei ein Kondensator (1020) zwischen einer ersten Verdrahtung, die den Gate-Treiber mit dem ersten Leiter verbindet, und einer zweiten Verdrahtung, die den Gate-Treiber mit dem zweiten Leiter verbindet, verbunden ist, wobei der Kondensator (1020) auf der Seite des Gate-Treibers (320) durch den Verdrahtungskörper (108) von dem Schaltmodul (300) beabstandet angeordnet ist, wobei das Schaltmodul einen Strom basierend auf einer Rückkopplungskapazität zwischen einem Hauptanschluss des Schaltmoduls und dem Steueranschluss in den Kondensator (1080) durch den Verdrahtungskörper akkumuliert, sodass Schwankungen einer Spannung des Steueranschlusses unterdrückt werden, indem die Induktivität zwischen dem Schaltmodul (300) und dem Gate-Treiber (320) mit dem Verdrahtungskörper (180) verringert wird,

wobei der Verdrahtungskörper einen ersten Leiter (108A) und einen zweiten Leiter (108B) umfasst,

wobei der erste Leiter und der zweite Leiter unter Verwendung von flachen Platten ausgelegt sind, die parallel zueinander angeordnet sind,

wobei der erste Leiter einen Anschluss der Steueranschlüsse des Schaltmoduls mit einem Anschluss der Ausgangsanschlüsse des Gate-Treibers verbindet,

wobei der zweite Leiter den anderen Anschluss der Steueranschlüsse des Schaltmoduls mit dem anderen Anschluss der Ausgangsanschlüsse des Gate-Treibers verbindet,

wobei, wenn die jeweilige Breite des ersten Leiters und des zweiten Leiters W ist und ein Abstand zwischen dem ersten Leiter und dem zweiten Leiter d ist, W/d≥5 erfüllt ist.

**Revendications**

1. Dispositif de conversion de puissance (1) qui convertit une puissance entre un courant continu, CC, et un courant alternatif, CA, le dispositif comprenant :

   un module de commutation (300) qui inclut un élément semi-conducteur de puissance (305) en tant qu'élément de commutation ;
   un dispositif d'entraînement de grille (320) qui délivre en sortie un signal d'entraînement pour entraîner l'élément de commutation vers une borne de commande du module de commutation ; et
   un corps de câblage (108) qui connecte les bornes de commande du module de commutation et les bornes de sortie du dispositif d'entraînement de grille en utilisant une pluralité de conducteurs (108A, 108B) opposés les uns aux autres de manière plane avec un intervalle entre eux,
   dans lequel le corps de câblage inclut un premier conducteur (108A) et un second conducteur (108B) en tant que pluralité de conducteurs,
   dans lequel le premier conducteur et le second conducteur sont configurés en utilisant des plaques plates qui sont agencées mutuellement parallèlement,
   dans lequel le premier conducteur connecte une borne des bornes de commande du module de commutation à une borne des bornes de sortie du dispositif d'entraînement de grille,
   dans lequel le second conducteur connecte l'autre borne des bornes de commande du module de commutation à l'autre borne des bornes de sortie du dispositif d'entraînement de grille,
   dans lequel, lorsque chaque largeur du premier conducteur et du second conducteur est W et qu'un intervalle entre le premier conducteur et le second conducteur est d, W/d ≥ 5 est satisfaite, et
   dans lequel un condensateur (1020) est connecté entre un premier câblage connectant le dispositif d'entraînement de grille au premier conducteur et un second câblage connectant le dispositif d'entraînement de grille au second conducteur,
   dans lequel le condensateur (1020) est positionné sur le côté du dispositif d'entraînement de grille (320) à l'écart du module de commutation (300) à travers le corps de câblage (108),
   dans lequel le module de commutation accumule un courant sur la base d'une capacité de rétroaction (307) entre une borne principale du module de commutation et la borne de commande dans le condensateur (1020) à travers le corps de câblage, de sorte que la fluctuation d'une tension de la borne de commande est supprimée en réduisant l'inductance entre le module de commutation (300) et le dispositif d'entraînement de grille (320) avec le corps de câblage (108).

2. Dispositif de conversion de puissance selon la revendication 1,
   dans lequel un circuit de sortie du dispositif d'entraînement de grille inclut un MOSFET.

3. Dispositif de conversion de puissance selon la revendication 1,
   dans lequel une résistance (2010) est connectée en série au condensateur connecté au premier câblage et au second câblage.

4. Dispositif de conversion de puissance selon la revendication 1,
   dans lequel un absorbeur de surtension (4010) est connecté en parallèle au condensateur connecté au premier câblage et au second câblage.

5. Dispositif de conversion de puissance selon la revendication 1,
   dans lequel l'élément de commutation est un transistor bipolaire à grille isolée ou un transistor à effet de champ métal-oxyde-semiconducteur.

6. Dispositif de conversion de puissance selon la revendication 1,
   dans lequel le dispositif d'entraînement de grille est agencé à l'écart du module de commutation dans une plage de 50 cm à 1 m.

7. Procédé de conversion de puissance utilisant un dispositif de conversion de puissance (1) qui convertit une puissance entre CC et CA et qui comprend un module de commutation (300) qui inclut un élément semi-conducteur de puissance (305) en tant qu'élément de commutation, un dispositif d'entraînement de grille (320) qui délivre en sortie un signal d'entraînement pour entraîner l'élément de commutation vers une borne de commande du module de commutation, et un corps de câblage (108) qui connecte les bornes de commande du module de commutation et les bornes de sortie du dispositif d'entraînement de grille,

dans lequel le corps de câblage connecte la borne de commande et une borne de sortie du dispositif d'entraînement de grille en utilisant une pluralité de conducteurs opposés les uns aux autres de manière plane avec un intervalle entre eux,

dans lequel un condensateur (1020) est connecté entre un premier câblage connectant le dispositif d'entraînement de grille au premier conducteur et un second câblage connectant le dispositif d'entraînement de grille au second conducteur,

dans lequel le condensateur (1020) est positionné sur le côté d'entraînement de grille (320) à l'écart du module de commutation (300) à travers le corps de câblage (108), dans lequel le module de commutation accumule un courant sur la base d'une capacité de rétroaction entre une borne principale du module de commutation et la borne de commande dans le condensateur (1080) à travers le corps de câblage, de sorte que la fluctuation d'une tension de la borne de commande est supprimée en réduisant l'inductance entre le module de commutation (300) et le dispositif d'entraînement de grille (320) avec le corps de câblage (108),

dans lequel le corps de câblage inclut un premier conducteur (108A) et un second conducteur (108B),

dans lequel le premier conducteur et le second conducteur sont configurés en utilisant des plaques plates qui sont agencées mutuellement parallèlement,

dans lequel le premier conducteur connecte une borne des bornes de commande du module de commutation à une borne des bornes de sortie du dispositif d'entraînement de grille,

dans lequel le second conducteur connecte l'autre borne des bornes de commande du module de commutation à l'autre borne des bornes de sortie du dispositif d'entraînement de grille, dans lequel lorsque chaque largeur du premier conducteur et du second conducteur est W et qu'un intervalle entre le premier conducteur et le second conducteur est d, $W/d \geq 5$ est satisfaite.

## FIG.1

## FIG.2

# FIG.3

# FIG.4

(A)

Vac

Ia

(B) Ig

(C) Vt
Vg

t1  t2  t3                                         t

# FIG.5

320

309

309

307  301

Igres

303

308

306

305

331

# FIG.6

# FIG.7

# FIG.8

# FIG.9

EP 3 678 287 B1

EP 3 678 287 B1

# FIG.10

FIG.11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015198545 A

- JP H10257754 B

**Non-patent literature cited in the description**

- Gate-Driver with Full Protection for SiC-MOSFET Modules. **KARSTEN FINK ; ANDREAS VOLKE.** VDE Conference Publication. Power Integrations GmbH, 28 June 2016